# EUROPEAN PATENT SPECIFICATION

(11) **EP 2 674 972 B1**
(45) Date of publication and mention of the grant of the patent: **06.01.2016**
(21) Application number: 11858411.9
(22) Date of filing: 10.02.2011
(51) Int. Cl.: H01L 23/473, B61C 17/00, H05K 7/20, F28D 15/00

(54) **COOLING DEVICE AND POWER CONVERSION DEVICE**
KÜHLVORRICHTUNG UND LEISTUNGSUMWANDLUNGSVORRICHTUNG
DISPOSITIF DE REFROIDISSEMENT, ET DISPOSITIF DE CONVERSION D'ÉNERGIE ÉLECTRIQUE

(43) Date of publication of application: 18.12.2013
(73) Proprietor: Mitsubishi Electric Corporation, Tokyo 100-8310 (JP)
(72) Inventor: KOBAYASHI, Tomohiro, Chiyoda-ku, Tokyo 100-8310 (JP); ONO, Yoshitaka, Chiyoda-ku, Tokyo 100-8310 (JP); NAKASHIMA, Yukio, Chiyoda-ku, Tokyo 100-8310 (JP)
(74) Representative: Zech, Stefan Markus
(86) International application number: PCT/JP2011/052942
(87) International publication number: WO 2012/108053

(56) References cited:
- JP-A- 3 046 355
- JP-A- 6 097 338
- JP-A- 9 199 648
- JP-A- H09 199 648
- JP-A- 2002 146 858
- JP-A- 2005 229 033
- JP-A- 2005 354 000
- JP-A- 2009 537 998
- US-A1- 2009 236 081

## Description

### Field

The present invention relates to a cooling device of a circulating-liquid cooling system and a power conversion device that is configured to be coolable by this type of cooling device.

### Background

According to a cooling device of a circulating-liquid cooling system, as a coolant (a cooling liquid) of the cooling device, it has been conventionally required to add a required amount of additive to the coolant to reduce the freezing temperature of the cooling liquid to be lower than a minimum temperature in specifications required for the cooling device. The additive for reducing the freezing temperature generally causes degradation in cooling performance. Therefore, there is a problem that, to achieve sufficient cooling performance in a high temperature state, the size of the cooling device becomes large.

Meanwhile, Patent Literature 1 mentioned below discloses the following technique. That is, in a case where an inverter device is connected to a cooling device by a cooling pipe, cooling water from the cooling device is caused to pass through the cooling pipe and circulate therethrough to cool the inverter device, when the temperature of the cooling water is reduced because of a reduction in an outdoor air temperature, the inverter device is caused to perform no-load running to generate heat and the temperature of the cooling water is increased by the heat, thereby preventing freezing of the cooling water.

Document US 2009/0236081 A1 discloses a device for preheating a component cooled by conduction.

### Citation List

### Patent Literature

Patent Literature 1: Japanese Patent Application Laid-open No. H09-199648

### Summary

### Technical Problem

However, the technique disclosed in Patent Literature 1 mentioned above is a technique of preventing freezing of a cooling device, and thus there is a problem that when freezing of the cooling device is expected, the inverter device needs to be operated even though the cooling device is in a non-operating state.

It is conceivable to use the technique described in Patent Literature 1 mentioned above and configure a cooling device that allows temporary freezing in its non-operating state. However, according to such a device, for example, in a case where a part of a cooling pipe through which a cooling liquid passes is long, even when the inverter device is caused to perform no-load running to generate heat, while a circulation cooling function is not performed because a part of the cooling pipe is still frozen, the temperature of a semiconductor switching element serving as a cooled body exceeds an allowable maximum temperature. Accordingly, there is a problem that when the inverter device continues running in this state, the semiconductor switching element may be damaged.

In a case of such a device, it is also conceivable that no-load running of the inverter device is temporarily stopped to wait until the temperature of the semiconductor switching element is reduced and then the no-load running is performed again. However, with this method, the inverter device needs to be run and stopped repeatedly and thus there is a problem that it requires a long time to cause the cooling device to be in an operating state.

The present invention has been achieved in view of the above problems, and an object of the present invention is to provide a cooling device that allows temporary freezing in a non-operating state without executing any warming control for preventing freezing and that effectively melts a frozen cooling liquid in a cooling pipe without using any preheating device and the like to be capable of shifting to an operable state in a short time, and a power conversion device including the cooling device.

### Solution to Problem

In order to solve the above problem and in order to attain the above object, the present invention provides a cooling device according to independent claims 1 and 2.

Further embodiments of the invention may be realised in accordance with the dependent claims.

The present invention can provide a cooling device that allows temporary freezing in a non-operating state without executing any warming control for preventing freezing and that effectively melts a frozen cooling liquid in a cooling pipe (5) without using any preheating device and the like to be capable of shifting to an operable state in a short time, and a power conversion device including the cooling device.

### Brief Description of Drawings

FIG. 1 is a schematic diagram of a cooling configuration of a cooling device according to a first embodiment.
FIG. 2 depicts a circuit configuration of a power conversion device according to the first embodiment.
FIG. 3 depicts a configuration including temperature sensors at periphery parts of a radiator and a circulating pump.
FIG. 4 is a schematic diagram of a cooling configuration of a cooling device according to a second embodiment.

### Description of Embodiments

Exemplary embodiments of a cooling device and a power conversion device according to the present invention will be explained below in detail with reference to the accompanying drawings. The present invention is not limited to the embodiments.

### First embodiment.

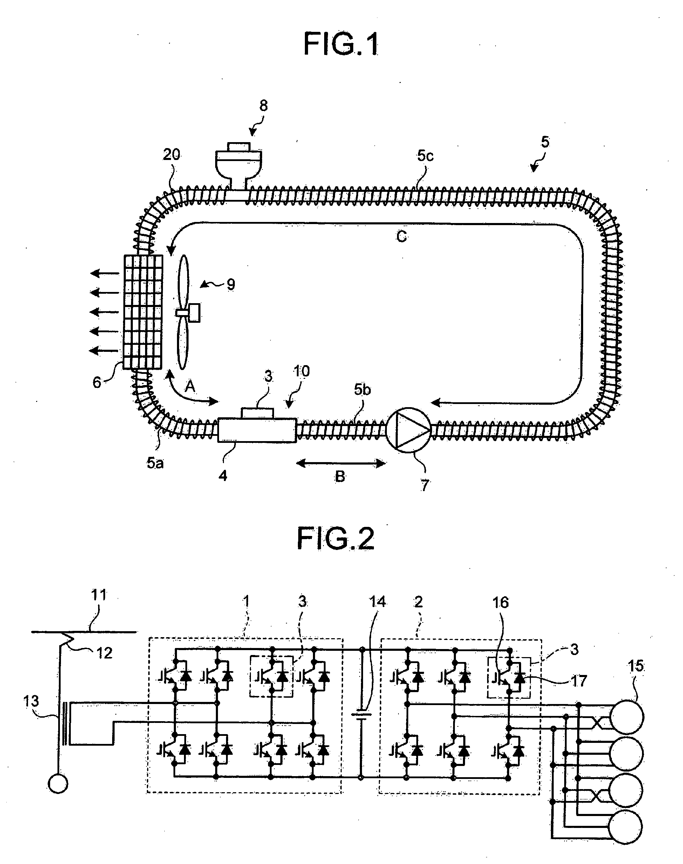

FIG. 1 is a schematic diagram of a cooling configuration of a cooling device according to a first embodiment of the present invention. In FIG. 1, a cooling pipe 5 is a flexible hollow pipe made of a material such as resin, and connects a switching element module 10 that is a heat generation source and also serves as a cooled body, a radiator 6 that is a heat exchanger that cools a cooling liquid serving as a cooling medium, a circulating pump 7 for circulating the cooling liquid, and a reserve tank 8 that replenishes a cooling liquid to absorb a change in the volume of the cooling liquid. A blower 9 for forcibly cooling the cooling liquid is mounted on the radiator 6. The switching element module 10 is configured to include a switching element 3 and a heat sink 4, and the cooling pipe 5 is inserted into the heat sink 4.

The switching element module 10 is arranged between the radiator 6 and the circulating pump 7. In view of the overall configuration of the cooling pipe 5, the switching element module 10, the radiator 6, and the circulating pump 7 are arranged adjacently. A metal spiral 20 formed by spirally winding a metal material is provided on the cooling pipe 5. This metal spiral 20 is wound so as to closely contact an outer circumferential surface of the cooling pipe 5 and so that spiral parts are closely adjacent to each other, thereby swiftly moving heat generated in the switching element module 10 to every part of the cooling pipe 5.

As shown in FIG. 1, the cooling pipe 5 is divided into three parts, that is, cooling pipes 5a, 5b, and 5c. The cooling pipe 5a is a part arranged between the radiator 6 and the heat sink 4, the cooling pipe 5b is a part arranged between the heat sink 4 and the circulating pump 7, and the cooling pipe 5c is a part arranged between the radiator 6 and the circulating pump 7. It is assumed that a path length of the cooling pipe 5a, that is, a path length (a first path length) between the radiator 6 along the cooling pipe 5 on a side not including the circulating pump 7 and the heat sink 4 (the switching element module 10) is denoted by A. Similarly, it is assumed that a path length of the cooling pipe 5b, that is, a path length (a second path length) between the circulating pump 7 along the cooling pipe 5 on a side not including the radiator 6 and the heat sink 4 (the switching element module 10) is denoted by B, and a path length of the cooling pipe 5c, that is, a path length (a third path length) between the radiator 6 along the cooling pipe 5 on a side not including the heat sink 4 (the switching element module 10) and the circulating pump 7 is denoted by C. When the respective path lengths are defined as described above, relationships of A<C and B<C are established between these first to third path lengths. Meanwhile, a relationship between A and B is not uniquely determined because the magnitude relationship therebetween may change depending on a heat capacity of the radiator 6 and the circulating pump 7. Relationships among the path lengths A, B, and C are described in more detail later.

As the cooling liquid in the cooling pipe 5, it is possible to use water, an aqueous solution containing additive (for example, ethylene glycol) that suppresses freezing of the cooling liquid at a low temperature, or an oleaginous solution. A cooling liquid that brings out the significance and effects of the cooling device according to the present embodiment most is water in which an antifreezing liquid such as ethylene glycol is not mixed. Because the antifreezing liquid reduces a heat conductivity of the cooling liquid and its cooling performance, it is preferable to avoid mixing of any impurity with the cooling liquid as much as possible.

FIG. 2 depicts a circuit configuration of a power conversion device according to the first embodiment. The power conversion device shown in FIG. 2 is a configuration example of a power conversion device applied to an alternating-current-input electric vehicle, and is configured to include a converter unit 1, an inverter unit 2, and a filter capacitor 14.

In FIG. 2, an alternating current collected from an overhead line 11 via a pantograph 12 is stepped down by a transformer 13 and is converted into a direct current by the converter unit 1. The power converted into a direct current is output via the filter capacitor 14 to an induction motor 15 as a three-phase alternating current of a variable-voltage variable-frequency generated by the inverter unit 2 to control acceleration and deceleration of, for example, an electric vehicle having the induction motor 15 being incorporated therein.

A plurality of the switching elements 3 that configure the converter unit 1 and the inverter unit 2 described above are configured by using, for example, a self-extinction semiconductor device such as an IGBT (Insulated Gate Bipolar Transistor). In the case of the switching element 3 according to the present embodiment, as shown in FIG. 2, a switching element in which an IGBT 16 and a diode 17 connected in antiparallel to the IGBT 16 are integrally modularized is exemplified.

While FIG. 2 depicts a case of applying the power conversion device according to the first embodiment to the alternating-current-input electric vehicle as a preferable example of the power conversion device, the power conversion device can be similarly applied to a direct-current-input electric vehicle that is widely used for a subway, a suburban electric vehicle, and the like. When the power conversion device is applied to the direct-current-input electric vehicle, the configuration thereof can be identical to that of FIG. 2, except that the transformer 13 and the converter unit 1 become unnecessary, and it is needless to mention that the contents of the present embodiment can be also applied to the direct-current-input electric vehicle.

Next, an operation of the cooling device according to the present embodiment at a normal time is explained. In the configuration described above, when the power conversion device is operated, the switching element 3 generates heat. The switching element 3 is cooled by the heat sink 4. Meanwhile, a cooling liquid whose temperature is increased by heat radiation from the switching element 3 via the heat sink 4 is moved in the cooling pipe 5 by the circulating pump 7 and is cooled in the radiator 6 by heat exchange with air. An increase in the temperature of the switching element 3 is suppressed in this way, and a continuous operation of the power conversion device can be performed.

Next, a precondition in the cooling device according to the present embodiment is explained. The precondition is that a freezing temperature of a coolant (a cooling liquid) used for the cooling device according to the present embodiment is higher than a minimum temperature in specifications applied to the cooling device. In a case where the minimum temperature in the specifications applied to the cooling device is -10°C, for example, when water is used as the coolant, for example, a relationship of "minimum temperature (-10°C) < freezing temperature (0°C)" is established. Furthermore, in a case where the minimum temperature in the specifications applied to the cooling device is -40°C, for example, even when a required amount of ethylene glycol, for example, is added as an antifreezing agent to the coolant to set the freezing temperature to about -20°C, for example, a relationship of "minimum temperature (-40°C) < freezing temperature (-20°)" is established.

In a case where the minimum temperature in the specifications applied to the cooling device is -40°C, for example, when an outdoor air temperature is -50°C because of a severe cold wave that may happen once in ten-odd years, unexpected freezing of the cooling liquid occurs. However, when a cooling device is configured with the precondition described above, that is, when a cooling device is configured while assuming that a cooling liquid is frozen, it is possible to handle such unexpected freezing of the cooling liquid swiftly and without any problem. Furthermore, there is an advantage such that even though the device is not designed to handle events that occur with a very low probability, the device can handle such events. This advantage can greatly contribute to cost reduction and downsizing of the device.

Next, an operation of the cooling device according to the present embodiment at the time of freezing is explained with reference to FIG. 1. When a cooling liquid is frozen, the cooling liquid does not circulate in the cooling pipe 5 and thus a cooling device does not function. Meanwhile, according to the cooling device of the present embodiment, when the cooling liquid is frozen, the switching element module 10 is forcibly operated. When the switching element module 10 is operated, the switching element 3 generates heat and thus the amount of the heat is moved to the heat sink 4 and transferred to the metal spiral 20. The metal spiral 20 is formed by using a material having a high conductivity such as copper or silver. Furthermore, according to the cooling device of the present invention, because a path length between the heat sink 4 and the radiator 6 and a path length between the heat sink 4 and the circulating pump 7 are short, heat transfer to the radiator 6 and the circulating pump 7 that have a large heat capacity is performed in a short time.

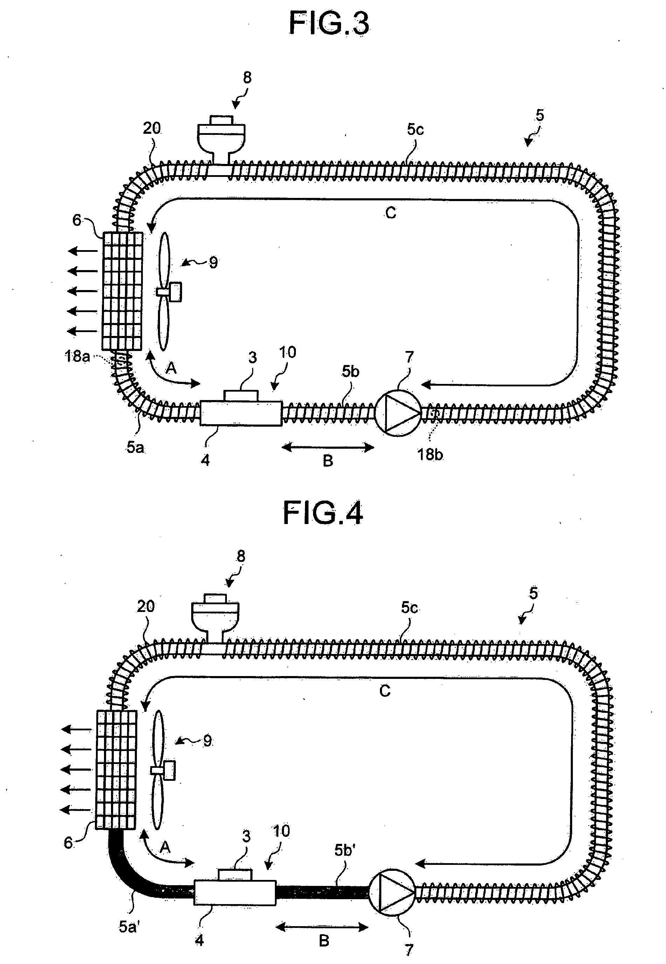

When the cooling liquid in the radiator 6 and the circulating pump 7 that have a large heat capacity is melted, any other structures having a large capacity do not exist other than the cooling pipe 5. When the cooling liquid in the radiator 6 and the circulating pump 7 that have a large heat capacity is melted, it is expected that a part of the cooling liquid in the cooling pipe 5c is also melted and the entire cooling liquid is liquefied in a sherbet state. Accordingly, by operating the circulating pump 7 in addition to the switching element module 10, effects of heat transfer are increased and a speed at which the cooling device enters in an operable state can be increased. For example, as shown in FIG. 3, it suffices to respectively provide temperature sensors 18a and 18b at periphery parts of the radiator 6 and the circulating pump 7 and to operate the circulating pump 7 when either the temperature sensor 18a or 18b has a value equal to or larger than a predetermined value.

The number of temperature sensors does not need to be two. It is permissible to provide only one temperature sensor, or to provide three or more temperature sensors. The position of the temperature sensor is not particularly limited as long as it is on a circulation path of the cooling liquid, but it is more preferable that the temperature sensor is provided at the periphery part of the radiator 6 or the circulating pump 7.

As shown in FIG. 1, in the present embodiment, while the reserve tank 8 is arranged on the cooling pipe 5c that is the longest among cooling pipes, the reserve tank 8 can be connected to other pipe parts (the cooling pipes 5a and 5b) because the heat capacity of the reserve tank 8 is not larger than that of the radiator 6 and the circulating pump 7.

While the present embodiment has explained that the magnitude relationship between the first path length A and the second path length B is not uniquely determined. However, when a different in the heat capacity between the radiator 6 and the circulating pump 7 is large, to allow a structure having a large heat capacity and a structure having a small heat capacity to be melted substantially at the same time, it suffices to arrange a cooling pipe so that a path length of a cooling pipe connected to the structure having a large heat capacity is short.

While the present embodiment has described a material having a high heat conductivity such as copper or silver as the metal material (the metal spiral) that is spirally wound around the cooling tube 5, the metal material is not limited to this type of metal material. For example, it is believed that some carbon nanotubes have a heat conductivity that is ten to ten-odd times larger than that of silver or copper. While the system of supplying carbon nanotubes has not been fully established as of filing of the present application, a technique related to the carbon nanotubes will become a breakthrough technique and it is preferable to use the carbon nanotubes for the cooling device according to the present embodiment.

While the present embodiment has described that the metal material is wound around the entire circumference of the cooling pipe 5 as shown in FIG. 1, the present invention is not limited thereto. For example, the metal material can be wound around only the cooling pipe 5a or the cooling pipe 5b, for example.

As explained above, according to the cooling device of the present embodiment, the cooling performance at a high temperature can be improved without using any additive that reduces a freezing temperature, or even when the additive is used, by suppressing the amount of the additive. Furthermore, any additional device such as a preheating device or a warming device is unnecessary.

According to the cooling device of the present embodiment, because any additive that reduces the freezing temperature is not used, or even when it is used, the amount of the additive can be suppressed, the cooling performance at a high temperature can be improved, and the device can be downsized with the same cooling performance.

According to the cooling device of the present embodiment, because a pipe made of flexible resin can be used as a cooling pipe, the cooling pipe can be arranged with flexibility.

According to the cooling device of the present embodiment, a metal material is spirally wound around the cooling pipe to closely and adjacently contact the cooling pipe, so that, even when the heat generation source suddenly generates heat, the cooling liquid in the overall cooling device is rapidly liquefied to recover a cooling function. Furthermore, there is adopted a configuration in which a switching element module serving as a heat generation source is arranged between a radiator and a circulating pump. Accordingly, the cooling device can be caused to shift to an operable state before the switching element reaches a maximum allowable temperature.

According to the cooling device of the present invention, because the device is configured while assuming that a cooling liquid is frozen, it is possible to handle such unexpected freezing of the cooling liquid swiftly and without any problem. Furthermore, there is an advantage such that even though the device is not designed to handle events that occur with a very low probability, the device can handle such events. This advantage can greatly contribute to cost reduction and downsizing of the device.

### Second embodiment.

FIG. 4 is a schematic diagram of a cooling configuration of a cooling device according to a second embodiment of the present invention. According to the cooling device of the first embodiment, the metal spiral 20 is wound around the cooling pipe 5a arranged between the radiator 6 and the heat sink 4 and the cooling pipe 5b arranged between the heat sink 4 and the circulating pump 7. On the other hand, according to the second embodiment, these cooling pipes 5a and 5b are configured as cooling pipes 5a' and 5b' serving as a metal pipe.

When the flexible cooling pipes 5a and 5b are used as in the first embodiment, while a cooling pipe can be flexibly arranged, the metal spiral 20 needs to be wound around the cooling pipes 5a and 5b. On the other hand, when the metal cooling pipes 5a' and 5b' are used as in the present embodiment, any operation of winding the metal spiral 20 around the cooling pipes 5a' and 5b' is unnecessary. Furthermore, in a case of the cooling device according to the first and second embodiments, because a distance between the radiator 6 and the heat sink 4 and a distance between the circulating pump 7 and the heat sink 4 are short, a metal pipe having a high heat conductivity can be used.

It is preferable to form the cooling pipes 5a' and 5b' by using metal having a high heat conductivity such as silver or copper. When the metal having a high heat conductivity is used, heat transfer between the radiator 6 and the heat sink 4 and between the circulating pump 7 and the heat sink 4 is swiftly performed and thus effects identical to those of the first embodiment can be achieved.

### Third embodiment.

A third embodiment explains a switching element included in the converter unit 1 and the inverter unit 2 of a power conversion device. As the switching element used in the power conversion device, a switching element in which a semiconductor transistor element made of silicon (Si) (an IGBT, a MOSFET, and the like) is connected in antiparallel to a semiconductor diode element also made of silicon is generally used. The techniques explained in the first and second embodiments can be used for an inverter unit and a converter unit each of which includes such a general switching element.

Meanwhile, the techniques explained in the first and second embodiments are not limited to a switching element made of silicon. It is of course possible to include a switching element made of, instead of silicon, silicon carbide (SiC) that has recently attracted attention in the converter unit 1 and the inverter unit 2.

Because silicon carbide has a characteristic that it can be used at a high temperature, when the switching element made of silicon carbide is used as the switching element included in the converter unit 1 or the inverter unit 2, an allowable operating temperature of a switching element module can be raised to be a high temperature. Therefore, when the switching element made of silicon carbide is used, the switching element can be caused to remain in an allowable temperature region even when the amount of heat generation per unit time is increased, and a melting speed of a frozen cooling liquid can be increased as compared to a case where the switching element made of silicon is used.

Silicon carbide (SiC) is an example of a semiconductor referred to as "wide bandgap semiconductor", because of a characteristic that it has a bandgap larger than silicon (Si). In addition to this silicon carbide, for example, a semiconductor made of a gallium nitride-based material or a semiconductor formed by using diamond are also a wide bandgap semiconductor and characteristics of these materials are similar to those of silicon carbide. Therefore, configurations using a wide bandgap semiconductor other than that made of silicon carbide also form the scope of the present invention.

Because a transistor element and a diode element that are formed of such a wide bandgap semiconductor have a high voltage resistance and a high allowable current density, the transistor element and the diode element can be downsized. By using these downsized transistor element and diode element, a semiconductor module having these elements incorporated therein can be downsized.

Because the transistor element and the diode element formed of a wide bandgap semiconductor also have a high heat resistance, a heat sink can be downsized and a switching element module can be further downsized.

Furthermore, because the transistor element and the diode element formed of a wide bandgap semiconductor have a reduced power loss, the efficiency of the switching element and the diode element can be increased and thus the efficiency of the switching element module can be increased.

### Industrial Applicability

As described above, the present invention is useful as a cooling device of a circulating-liquid cooling system and a power conversion device that is configured to be coolable by this type of cooling device.

### Reference Signs List

- 1: converter unit
- 2: inverter unit
- 3: switching element
- 4: heat sink
- 5, 5a, 5b, 5c, 5a', 5b': cooling pipe
- 6: radiator
- 7: circulating pump
- 8: reserve tank
- 9: blower
- 10: switching element module
- 11: overhead line
- 12: pantograph
- 13: transformer
- 14: filter capacitor
- 15: induction motor
- 16: IGBT
- 17: diode
- 20: metal spiral

## Claims

1. A cooling device of a circulating-liquid cooling system that connects two of respective elements of a heat exchanger (6), a circulating pump (7), and a cooled body by a cooling pipe (5),
wherein the cooled body is arranged between the heat exchanger (6) and the circulating pump (7),
**characterised in that**
each of a first path length (A) that is a path length between the heat exchanger (6) along the cooling pipe (5) on a side not including the circulating pump (7) and the cooled body and a second path length (B) that is a path length between the circulating pump (7) along the cooling pipe (5) on a side not including the heat exchanger (6) and the cooled body is set to be shorter than a third path length (C) that is a path length between the heat exchanger (6) along the cooling pipe (5) on a side not including the cooled body and the circulating pump (7), and
a metal material (20) having a high thermal conductivity is spirally wound around the cooling pipe (5) so as to contact an outer circumferential surface of the cooling pipe (5), the metal material (20) provided such that heat from the cooled body can be transferred to the metal material (20).

2. A cooling device of a circulating-liquid cooling system that connects two of respective elements of a heat exchanger (6), a circulating pump (7), and a cooled body by a cooling pipe (5),
wherein the cooled body is arranged between the heat exchanger (6) and the circulating pump (7),
**characterised in that**
each of a first path length (A) that is a path length between the heat exchanger (6) along the cooling pipe (5) on a side not including the circulating pump (7) and the cooled body and a second path length (B) that is a path length between the circulating pump (7) along the cooling pipe (5) on a side not including the heat exchanger (6) and the cooled body is set to be shorter than a third path length (C) that is a path length between the heat exchanger (6) along the cooling, pipe (5) on a side not including the cooled body and the circulating pump (7), and
a metal material (20) having a high thermal conductivity is spirally wound around a part of the third path length (C) of the cooling pipe (5) so as to contact an outer circumferential surface of the cooling pipe (5), and a part of the cooling pipe (5a', 5b') forming the first and second path lengths (A, B) is made of a metal material (20) having a high thermal conductivity, such that heat transfer between the circulating pump (7) and the cooled body can be performed.

3. The cooling device according to claim 1 or 2, wherein a freezing temperature of a cooling liquid that circulates in the cooling pipe (5) is set to be lower than a minimum temperature in specifications applied to the cooling device.

4. The cooling device according to claim 3, wherein a switching element module (10) that configures the cooled body is formed of a wide bandgap semiconductor.

5. The cooling device according to claim 4, wherein the wide bandgap semiconductor is a semiconductor using silicon carbide, a gallium nitride-based material, or diamond.

6. The cooling device according to claim 1 or 2, wherein a temperature sensor (18a, 18b) is provided on a circulation path of a cooling liquid.

7. A power conversion device that is configured so that a switching element module (10) serving as a cooled body can be cooled by a cooling device of a circulating-liquid cooling system of claim 1.

8. The power conversion device according to claim 7, wherein the metal material (20) having a high thermal conductivity is spirally wound around a part of the third path length (C) of the cooling pipe (5) and a part of the cooling pipe (5) forming the first and second path lengths (A, B) is made of a metal material (20) having a high thermal conductivity.

9. The power conversion device according to claim 7 or 8, wherein a freezing temperature of a cooling liquid that circulates in the cooling pipe (5) is set to be lower than a minimum temperature in specifications applied to the cooling device.

10. The power conversion device according to claim 9, wherein a switching element module (10) that configures the cooled body is formed of a wide bandgap semiconductor.

11. The power conversion device according to claim 10, wherein the wide bandgap semiconductor is a semiconductor using silicon carbide, a gallium nitride-based material, or diamond.

12. The power conversion device according to claim 7 or 8, wherein a temperature sensor (18a, 18b) is provided on a circulation path of a cooling liquid.

13. The cooling device according to claims 1 or 2, wherein the cooled body is a switching element (3) that is applied for a power conversion device.

14. The cooling device according to claim 13, wherein the switching element (3) is formed of a wide bandgap semiconductor.

## Patentansprüche

1. Kühlvorrichtung eines Umwälzflüssigkeitskühlsystems, das jeweils zwei Elemente aus einem Wärmetauscher (6), einer Umwälzpumpe (7) und einem gekühlten Körper mittels eines Kühlrohrs (5) verbindet,
wobei der gekühlte Körper zwischen dem Wärmetauscher (6) und der Umwälzpumpe (7) angeordnet ist,
**dadurch gekennzeichnet, dass**
sowohl eine erste Pfadlänge (A), bei der es sich um eine Pfadlänge zwischen dem Wärmetauscher (6) entlang des Kühlrohrs (5) auf einer die Umwälzpumpe (7) nicht enthaltenden Seite und dem gekühlten Körper handelt, als auch eine zweite Pfadlänge (B), bei der es sich um eine Pfadlänge zwischen der Umwälzpumpe (7) entlang des Kühlrohrs (5) auf einer den Wärmetauscher (6) nicht enthaltenden Seite und dem gekühlten Körper handelt, kürzer gesetzt sind als eine dritte Pfadlänge (C), bei der es sich um eine Pfadlänge zwischen dem Wärmetauscher (6) entlang des Kühlrohrs (5) auf einer den gekühlten Körper nicht enthaltenden Seite und der Umwälzpumpe (7) handelt, und
ein Metallmaterial (20) mit einer hohen Wärmeleitfähigkeit, eine Außenumfangsfläche des Kühlrohrs (5) berührend, spiralförmig um das Kühlrohr (5) gewunden ist, wobei das Metallmaterial (20) dergestalt vorgesehen ist, dass Wärme vom gekühlten Körper auf das Metallmaterial (20) übertragen werden kann.

2. Kühlvorrichtung eines Umwälzflüssigkeitskühlsystems, das jeweils zwei Elemente von einem Wärmetauscher (6), einer Umwälzpumpe (7) und einem gekühlten Körper mittels eines Kühlrohrs (5) verbindet,
wobei der gekühlte Körper zwischen dem Wärmetauscher (6) und der Umwälzpumpe (7) angeordnet ist,
**dadurch gekennzeichnet, dass**
sowohl eine erste Pfadlänge (A), bei der es sich um eine Pfadlänge zwischen dem Wärmetauscher (6) entlang des Kühlrohrs (5) auf einer die Umwälzpumpe (7) nicht enthaltenden Seite und dem gekühlten Körper handelt, als auch eine zweite Pfadlänge (B), bei der es sich um eine Pfadlänge zwischen der Umwälzpumpe (7) entlang des Kühlrohrs (5) auf einer den Wärmetauscher (6) nicht enthaltenden Seite und dem gekühlten Körper handelt, kürzer ausgebildet ist als eine dritte Pfadlänge (C), bei der es sich um eine Pfadlänge zwischen dem Wärmetauscher (6) entlang des Kühlrohrs (5) auf einer den gekühlten Körper nicht enthaltenden Seite und der Umwälzpumpe (7) handelt, und
ein Metallmaterial (20) mit einer hohen Wärmeleitfähigkeit, eine Außenumfangsfläche des Kühlrohrs (5) berührend, spiralförmig um einen Teil der dritten Pfadlänge (C) des Kühlrohrs (5) gewunden ist, und ein die erste und zweite Pfadlänge (A, B) bildender Teil des Kühlrohrs (5) aus einem Metallmaterial (20) mit einer Wärmeleitfähigkeit hergestellt ist, so dass eine Wärmeübertragung zwischen der Umwälzpumpe (7) und dem gekühlten Körper erfolgen kann.

3. Kühlvorrichtung nach Anspruch 1 oder 2, wobei eine Gefriertemperatur einer im Kühlrohr (5) zirkulierenden Kühlflüssigkeit niedriger angesetzt ist als eine Mindesttemperatur in auf die Kühlvorrichtung bezogenen Spezifikationen.

4. Kühlvorrichtung nach Anspruch 3, wobei ein Schaltelementmodul (10), das den gekühlten Körper bildet, aus einem Halbleiter mit großer Bandlücke besteht.

5. Kühlvorrichtung nach Anspruch 4, wobei es sich bei dem Halbleiter mit großer Bandlücke um einen Halbleiter handelt, der Siliciumcarbid, ein Material auf Galliumnitridbasis oder Diamant verwendet.

6. Kühlvorrichtung nach Anspruch 1 oder 2, wobei ein Temperatursensor (18a, 18b) an einem Umwälzpfad einer Kühlflüssigkeit vorgesehen ist.

7. Energieumwandlungsvorrichtung, die so ausgelegt ist, dass ein Schattelementmodul (10), das als gekühlter Körper dient, mittels einer Kühlvorrichtung eines Umwälzflüssigkeitskühlsystems nach Anspruch 1 gekühlt werden kann.

8. Energieumwandlungsvorrichtung nach Anspruch 7, wobei das Metallmaterial (20) mit einer hohen Wärmeleitfähigkeit spiralförmig um einen Teil der dritten Pfadlänge (C) des Kühlrohrs (5) gewunden ist, und eine die erste und zweite Pfadlänge (A, B) bildender Teil des Kühlrohrs (5) aus einem Metallmaterial (20) mit einer hohen Wärmeleitfähigkeit besteht.

9. Energieumwandlungsvorrichtung nach Anspruch 7 oder 8, wobei eine Gefriertemperatur einer im Kühlrohr (5) zirkulierenden Kühlflüssigkeit niedriger gesetzt ist als eine Mindesttemperatur in auf die Kühlvorrichtung bezogenen Spezifikationen.

10. Energieumwandlungsvorrichtung nach Anspruch 9, wobei ein Schaltelementmodul (10), das den gekühlten Körper bildet, aus einem Halbleiter mit großer Bandlücke besteht.

11. Energieumwandlungsvorrichtung nach Anspruch 10, wobei es sich bei dem Halbleiter mit großer Bandlücke um einen Halbleiter handelt, der Siliciumcarbid, ein Material auf Galliumnitridbasis oder Diamant verwendet.

12. Energieumwandlungsvorrichtung nach Anspruch 7 oder 8, wobei ein Temperatursensor (18a, 18b) an einem Umwälzpfad einer Kühlflüssigkeit vorgesehen ist.

13. Kühlvorrichtung nach Anspruch 1 oder 2, wobei es sich bei dem gekühlten Körper um ein Schaltelement (3) handelt, das für eine Energieumwandlungsvorrichtung angewendet wird.

14. Kühlvorrichtung nach Anspruch 13, wobei das Schaltelement (3) aus einem Halbleiter mit großer Bandlücke besteht.

## Revendications

1. Dispositif de refroidissement d'un système de refroidissement à liquide de circulation qui connecte respectivement deux éléments parmi un échangeur de chaleur (6), une pompe de circulation (7), et un corps refroidi, via une conduite de refroidissement (5),
sachant que le corps refroidi est agencé entre l'échangeur de chaleur (6) et la pompe de circulation (7),
**caractérisé en ce que**
aussi bien une première longueur de trajet (A) qui est une longueur de trajet entre l'échangeur de chaleur (6) le long de la conduite de refroidissement (5) d'un côté n'incluant pas la pompe de circulation (7) et le corps refroidi qu'une deuxième longueur de trajet (B) qui est une longueur de trajet entre la pompe de circulation (7) le long de la conduite de refroidissement (5) d'un côté n'incluant pas l'échangeur de chaleur (6) et le corps refroidi sont établis de manière à être plus courte qu'une troisième longueur de trajet (C) qui est une longueur de trajet entre l'échangeur de chaleur (6) le long de la conduite de refroidissement (5) d'un côté n'incluant pas le corps refroidi et la pompe de circulation (7), et
un matériau de métal (20) ayant une conductivité thermique élevée est enroulé hélicoïdalement autour de la conduite de refroidissement (5) de manière à être en contact avec une surface circonférentielle externe de la conduite de refroidissement (5), le matériau de métal (20) étant disposé de telle sorte que de la chaleur provenant du corps refroidi puisse être transférée au matériau de métal (20).

2. Dispositif de refroidissement d'un système de refroidissement à liquide de circulation qui connecte deux éléments parmi des éléments respectifs d'un échangeur de chaleur (6), d'une pompe de circulation (7), et d'un corps refroidi, via une conduite de refroidissement (5),
sachant que le corps refroidi est agencé entre l'échangeur de chaleur (6) et la pompe de circulation (7),
**caractérisé en ce que**
chacune d'une première longueur de trajet (A) qui est une longueur de trajet entre l'échangeur de chaleur (6) le long de la conduite de refroidissement (5) d'un côté n'incluant pas la pompe de circulation (7) et le corps refroidi et une deuxième longueur de trajet (B) qui est une longueur de trajet entre la pompe de circulation (7) le long de la conduite de refroidissement (5) d'un côté n'incluant pas l'échangeur de chaleur (6) et le corps refroidi est établie de manière à être plus courte qu'une troisième longueur de trajet (C) qui est une longueur de trajet entre l'échangeur de chaleur (6) le long de la conduite de refroidissement (5) d'un côté n'incluant pas le corps refroidi et la pompe de circulation (7), et
un matériau de métal (20) ayant une conductivité thermique élevée est enroulé hélicoïdalement autour d'une partie de la troisième longueur de trajet (C) de la conduite de refroidissement (5) de manière à être en contact avec une surface circonférentielle externe de la conduite de refroidissement (5), et une partie de la conduite de refroidissement (5a', 5b') formant la première et la deuxième longueur de trajet (A, B) est composée d'un matériau de métal (20) ayant une conductivité thermique élevée, de telle sorte qu'un transfert de chaleur entre la pompe de circulation (7) et le corps refroidi puisse être effectué.

3. Le dispositif de refroidissement selon la revendication 1 ou 2, dans lequel une température de congélation d'un liquide de refroidissement qui circule dans la conduite de refroidissement (5) est établie de manière à être plus basse qu'une température minimale dans des spécifications appliquées au dispositif de refroidissement.

4. Le dispositif de refroidissement selon la revendication 3, dans lequel un module à élément de commutation (10) qui configure le corps refroidi est constitué par un semiconducteur à large bande.

5. Le dispositif de refroidissement selon la revendication 4, dans lequel le semiconducteur à large bande est un semiconducteur utilisant du carbure de silicium, un matériau à base de nitrure de gallium, ou du diamant.

6. Le dispositif de refroidissement selon la revendication 1 ou 2, dans lequel une sonde de température (18a, 18b) est disposée sur un trajet de circulation d'un liquide de refroidissement.

7. Dispositif de conversion de puissance qui est configuré de telle sorte qu'un module à élément de commutation (10) servant de corps refroidi peut être refroidi par un dispositif de refroidissement d'un système de refroidissement à liquide de circulation de la revendication 1.

8. Le dispositif de conversion de puissance selon la revendication 7, dans lequel le matériau de métal (20) ayant une conductivité thermique élevée est enroulé hélicoïdalement autour d'une partie de la troisième longueur de trajet (C) de la conduite de refroidissement (5) et une partie de la conduite de refroidissement (5) formant la première et la deuxième longueur de trajet (A, B) est composée d'un matériau de métal (20) ayant une conductivité thermique élevée.

9. Le dispositif de conversion de puissance selon la revendication 7 ou 8, dans lequel une température de congélation d'un liquide de refroidissement qui circule dans la conduite de refroidissement (5) est établie de manière à être plus basse qu'une température minimale dans des spécifications appliquées au dispositif de refroidissement.

10. Le dispositif de conversion de puissance selon la revendication 9, dans lequel un module à élément de commutation (10) qui configure le corps refroidi est formé d'un semiconducteur à large bande.

11. Le dispositif de conversion de puissance selon la revendication 10, dans lequel le semiconducteur à large bande est un semiconducteur utilisant du carbure de silicium, un matériau à base de nitrure de gallium, ou du diamant.

12. Le dispositif de conversion de puissance selon la revendication 7 ou 8, dans lequel une sonde de température (18a, 18b) est disposée sur un trajet de circulation d'un liquide de refroidissement.

13. Le dispositif de refroidissement selon la revendication 1 ou 2, dans lequel le corps refroidi est un élément de commutation (3) qui est appliqué pour un dispositif de conversion de puissance.

14. Le dispositif de refroidissement selon la revendication 13, dans lequel l'élément de commutation (3) est constitué par un semiconducteur à large bande.
